# EUROPEAN PATENT APPLICATION

(11) **EP 4 174 931 A1**
(43) Date of publication of application: **03.05.2023**
(21) Application number: 21833607.1
(22) Date of filing: 25.06.2021
(51) Int. Cl.: H01L 23/12, H01S 5/022

(54) **PACKAGE FOR HOUSING ELECTRONIC ELEMENT, ELECTRONIC DEVICE, AND ELECTRONIC MODULE**

(30) Priority: 29.06.2020 JP 2020111241
(71) Applicant: Kyocera Corporation, Kyoto-shi, Kyoto 612-8501 (JP)
(72) Inventor: MATSUMOTO, Hisato, Kyoto-shi, Kyoto 612-8501 (JP)
(74) Representative: Viering, Jentschura & Partner mbB Patent- und Rechtsanwälte
(86) International application number: PCT/JP2021/024065
(87) International publication number: WO 2022/004574

(57) **Abstract**

An electronic element housing package includes a base and a lead frame. The base is made of resin. The lead frame includes a portion positioned inside the base and another portion exposed from the base. The base includes a recess including a step portion. The lead frame includes a lead surface, a first extension portion, and a second extension portion. The lead surface is exposed at the step portion and has a first side and a second side. The first extension portion extends outward from the lead surface beyond the first side. The first extension portion is positioned inside the base. The second extension portion extends outward from the lead surface beyond the second side. The second extension portion is positioned inside the base. The first side and the second side are two sides not facing one another.

## Description

### TECHNICAL FIELD

The present disclosure relates to an electronic element housing package, an electronic device, and an electronic module.

### BACKGROUND OF INVENTION

Japanese Unexamined Patent Application Publication No. 2004-281490 discloses an electronic element housing package formed by insert molding of resin around a lead frame of metal. The electronic element housing package includes a recess including a step portion, and a portion of the lead frame is exposed on the step portion. An electronic element is mounted inside the recess and is electrically connected to the portion (lead surface) of the lead frame exposed on the step portion by wire bonding.

### SUMMARY

### SOLUTION TO PROBLEM

An electronic element housing package according the present disclosure includes
a base made of resin; and
a lead frame including a portion positioned inside the base and another portion exposed from the base,
wherein the base includes:
   a recess including a step portion,
wherein the lead frame includes:
   a lead surface exposed at the step portion and having a first side and a second side;
   a first extension portion extending outward from the lead surface beyond the first side, the first extension portion being positioned inside the base; and
   a second extension portion extending outward from the lead surface beyond the second side, the second extension portion being positioned inside the base, and
wherein the first side and the second side are two sides not facing one another.

An electronic device according to the present disclosure includes the above-described electronic element housing package and an electronic element.

The electronic element is mounted inside the recess and is electrically connected to the lead frame.

An electronic module according to the present disclosure includes the above-described electronic device and a module substrate.

The electronic device is mounted on the module substrate.

### BRIEF DESCRIPTION OF THE DRAWINGS

FIG. 1 is a perspective view of an electronic element housing package according to a first embodiment of the present disclosure.
FIG. 2 is a perspective view of a lead frame of the first embodiment.
FIG. 3A is a plan view of the electronic element housing package of the first embodiment.
FIG. 3B is a sectional view taken along line B-B in FIG. 3A.
FIG. 3C is a sectional view taken along line C-C in FIG. 3A.
FIG. 3D is a back view of the electronic element housing package of the first embodiment.
FIG. 4A is a plan view of an electronic element housing package of a second embodiment.
FIG. 4B is a sectional view taken along line B-B in FIG. 4A.
FIG. 4C is a sectional view taken along line C-C in FIG. 4A.
FIG. 5A is a plan view of an electronic element housing package of a third embodiment.
FIG. 5B is a sectional view taken along line B-B in FIG. 5A.
FIG. 5C is a sectional view taken along line C-C in FIG. 5A.
FIG. 6A is a plan view of an electronic element housing package of a fourth embodiment.
FIG. 6B is a sectional view taken along line B-B in FIG. 6A.
FIG. 6C is a sectional view taken along line C-C in FIG. 6A.
FIG. 7A is a plan view of an electronic element housing package of a fifth embodiment.
FIG. 7B is a sectional view taken along line B-B in FIG. 7A.
FIG. 7C is a sectional view taken along line C-C in FIG. 7A.
FIG. 8 is a vertical sectional view of an electronic device and an electronic module according to an embodiment of the present disclosure.

### DESCRIPTION OF EMBODIMENTS

Hereinafter, embodiments of the present disclosure will be described in detail with reference to the drawings.

### (First Embodiment)

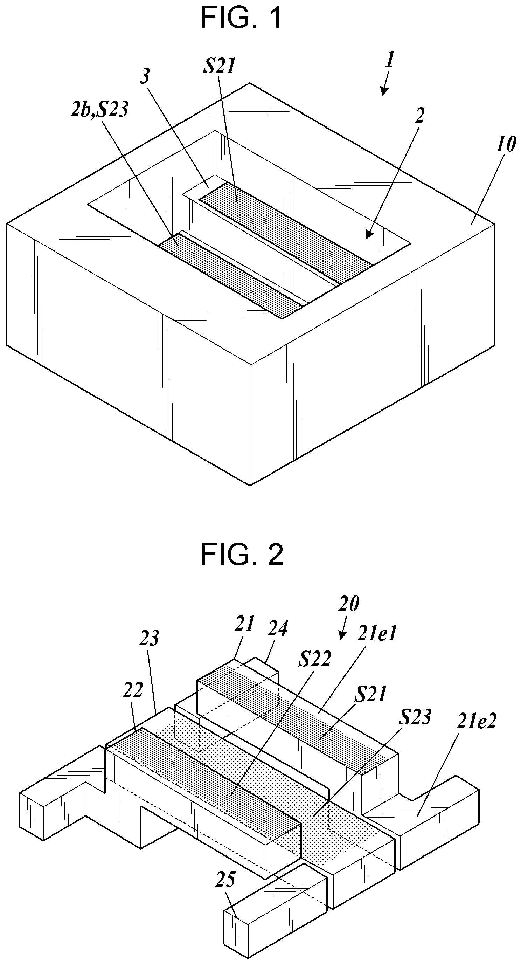

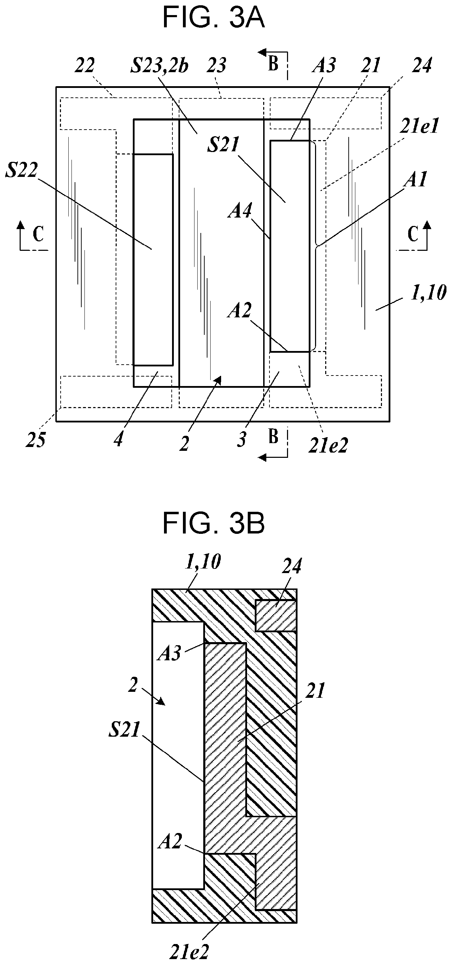

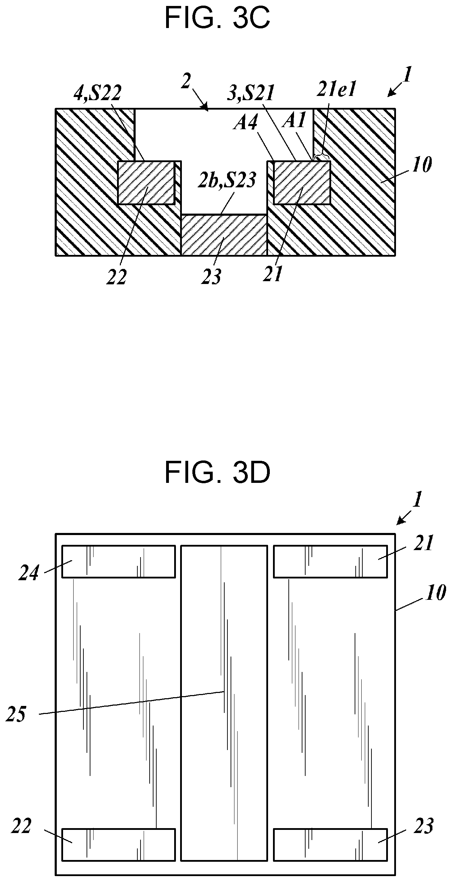

FIG. 1 is a perspective view of an electronic element housing package according to a first embodiment of the present disclosure. FIG. 2 is a perspective view of a lead frame of the first embodiment. FIG. 3A is a plan view of the electronic element housing package of the first embodiment. FIG. 3B is a sectional view taken along line B-B in FIG. 3A. FIG. 3C is a sectional view taken along line C-C in FIG. 3A. FIG. 3D is a back view of the electronic element housing package of the first embodiment. Hereinafter, the electronic element housing package is also simply referred to as a package.

A package 1 of the first embodiment is a premolded package housing an electronic element such as a surface-emitting laser chip. The package 1 includes a base 10 made of a resin and a lead frame 20 made of a metal. The package 1 is an insert-molded product formed by injecting a resin into a mold with the lead frame 20 therein.

The resin to be formed into the base 10 functions as an insulating material for the electronic element housing package 1. The resin to be formed into the base 10 may be required to have a function of resisting heat treatment, performed multiple times, such as solder reflow treatment at a temperature from 250°C to 300°C. To meet such a requirement, the resin used may be a thermoplastic resin typically having heat resistance, such as a liquid crystal polymer (LCP), polyether ether ketone (PEEK), polyamide imide (PAI), aromatic polyamide (PPA), polyphenylene sulfide (PPS), polyetherimide (PEI), polytetrafluoroethylene (PTFE), or the like. Among the above-described materials, the use of a liquid crystal polymer (LCP) is more effective in view of heat resistance and insert moldability.

The package 1 includes a recess 2. In the following description, the opening side of the recess 2 is referred to as the upper side. The recess 2 includes two step portions 3 and 4 (refer to FIG. 1, FIG. 3A, and FIG. 3C). The two step portions 3 and 4 are one step higher than an inner bottom portion 2b of the recess 2. The step portions 3 and 4 are positioned on both sides of the inner bottom portion 2b with the inner bottom portion 2b therebetween. The step portion 3 is long in one direction, and the step portion 4 is also long in the same direction as the step portion 3. In top view, in the lateral direction of each of the step portions 3 and 4, the step portion 3, the inner bottom portion 2b, and the step portion 4 are arranged in the following order: the step portion 3, the inner bottom portion 2b, and the step portion 4. The lateral direction means the direction of the shorter width of each of the step portions 3 and 4 in top view.

The lead frame 20 includes a portion positioned inside the base 10 and a portion exposed from the base 10. As the material of the lead frame 20, aluminum-based, iron-based, and copper-based materials, for example, are typically used. The use of a copper-based material, which is a material having high electrical resistance and high thermal conductivity, is more effective. The lead frame 20 includes first to fifth parts 21 to 25 separated from each other.

Each of the fourth part 24 and the fifth part 25 has a bottom surface exposed at the bottom of the base 10. The bottom surface functions as an external terminal for fixation to a substrate. Each of the fourth part 24 and the fifth part 25 is positioned inside the base 10 except for the bottom surface.

The third part 23 has an upper surface having a center surface S23 exposed at the inner bottom portion 2b of the recess 2. A portion of the center surface S23 functions as a mounting portion for an electronic element. The third part 23 has a bottom surface exposed at the bottom of the base 10. The bottom surface dissipates, to the outside, the heat guided from the electronic element.

The first part 21 has a lead surface S21 exposed at the step portion 3 (the upper surface of the step portion 3). The second part 22 has a lead surface S22 exposed at the step portion 4 (the upper surface of the step portion 4). The lead surfaces S21 and S22 are subjected to wire bonding. Terminals of the electronic element are electrically connected to the lead surfaces S21 and S22, respectively, by the wire bonding.

The lead surface S21 of the first part 21 has a rectangular shape. The longitudinal direction of the lead surface S21 is directed in the longitudinal direction of the step portion 3, and the lateral direction of the lead surface S21 is directed in the lateral direction of the step portion 3. The lead surface S21 has a first side A1 and a fourth side A4 both extending in the longitudinal direction and has a second side A2 and a third side A3 both extending in the lateral direction (FIGs. 3A to 3C).

The first part 21 includes an extension portion 21e1 extending outward from the lead surface S21 beyond the first side A1, and the extension portion 21e1 is positioned inside the base 10. The first part 21 further includes an extension portion 21e2 extending outward from the lead surface S21 beyond the second side A2, and the extension portion 21e2 is positioned inside the base 10. Extending outward from the lead surface S21 means extending outward relative to the lead surface S21 when viewed in a direction perpendicular to the lead surface S21. The extension portion 21e1 corresponds to an example of a first extension portion of the present disclosure. The extension portion 21e2 corresponds to an example of a second extension portion of the present disclosure.

The first side A1 and the second side A2 are two sides adjacent to one another and not facing one another. The first side A1 is positioned on the boundary between the upper surface of the step portion 3 and an inner wall surface of the recess 2.

The extension portion 21e2, extending from a portion thereof near the lead surface S21 toward an end portion thereof away from the lead surface S21, is bent downward and is then bent in a direction parallel to the lead surface S21. A portion of the lower surface of the extension portion 21e2 is exposed at the bottom of the base 10 (on the opposite side from the recess 2).

As describe above, since the first part 21 includes the extension portions 21e1 and 21e2 positioned behind two sides of the lead surface S21 not facing one another and positioned inside the base 10, the extension portions 21e1 and 21e2 produce an anchoring effect. Accordingly, the lead surface S21 can be suppressed from rising from the step portion 3. Thus, according to the lead surface S21 of the first embodiment, the lead surface S21 can be suppressed from rising even when a compressive stress and a tensile stress generated through reflow treatment performed multiple times are applied repeatedly to the first part 21.

According to the lead surface S21 of the first embodiment, the first side A1 in the longitudinal direction is positioned on the boundary between the inner wall surface of the recess 2 and the upper surface of the step portion 3, and the upper surface of the extension portion 21e1 and the lead surface S21 can be made as a continuous surface. Thus, the form of the lead frame 20 can be simplified. The force pressing the lead surface S21 can be increased because the first side A1 of the lead surface S21 is pressed against the wall body of the recess 2.

According to the lead surface S21 of the first embodiment, the extension portion 21e2 positioned behind the second side A2 produces a strong anchoring effect because the extension portion 21e2 is bent and includes a portion exposed at the bottom of the base 10.

The second part 22 and the lead surface S22 have structures same as, and/or similar to, the first part 21 and the lead surface S21, respectively, and exhibit the same and/or similar effects.

### (Second Embodiment)

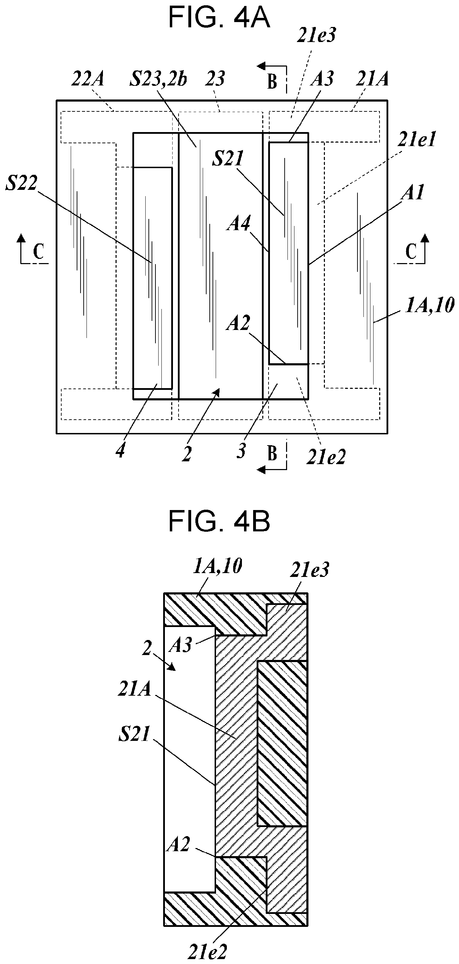

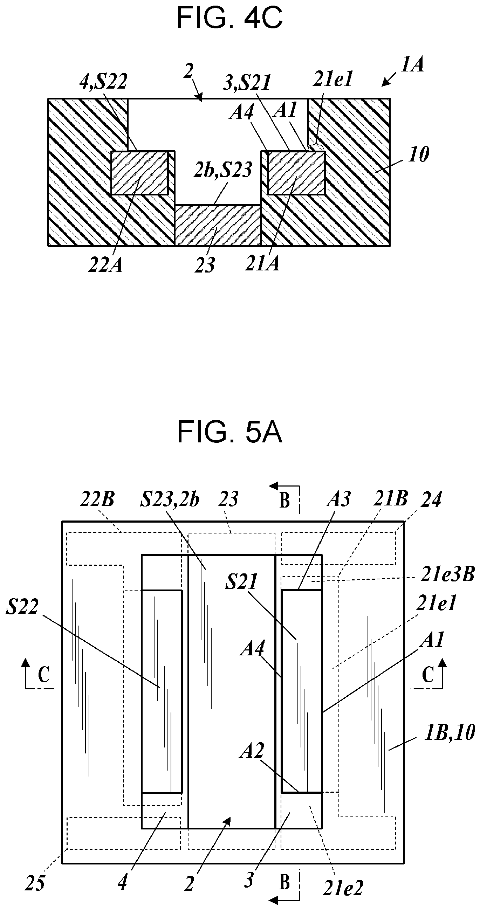

FIG. 4A is a plan view of an electronic element housing package of a second embodiment. FIG. 4B is a sectional view taken along line B-B in FIG. 4A. FIG. 4C is a sectional view taken along line C-C in FIG. 4A. A package 1A of the second embodiment has a configuration same as, and/or similar to, the configuration of the package 1 of the first embodiment except the configuration of parts of the lead frame 20 and a portion of the structure around each of the lead surfaces S21 and S22.

The lead frame 20 of the second embodiment includes a first part 21A, a second part 22A, and the third part 23. The first part 21A has the lead surface S21 exposed at the step portion 3. The second part 22Ahas the lead surface S22 exposed at the step portion 4.

In the same way as, and/or in a similar way to, the first embodiment, the first part 21A of the second embodiment includes the extension portions 21e1 and 21e2. The first part 21A of the second embodiment further includes an extension portion 21e3 extending outward from the lead surface S21 beyond the third side A3 and positioned inside the base 10. The third side A3 is a side extending in the lateral direction of the lead surface S21. The third side A3 and the first side A1 correspond to two sides not facing one another. The third side A3 and the second side A2 correspond to two sides facing one another. The extension portion 21e3 positioned behind the third side A3, extending from a portion thereof near the lead surface S21 toward an end portion thereof away from the lead surface S21, is bent downward first and is then bent in a direction parallel to the lead surface S21. A portion of the lower surface of the extension portion 21e3 is exposed at the bottom of the base 10. The extension portions 21e2 and 21e3 positioned behind the second side A2 and the third side A3, respectively, facing one another have shapes symmetrical to one another. The extension portion 21e3 corresponds to an example of a third extension portion of the present disclosure.

The second part 22A has a structure same as, and/or similar to, the structure of the first part 21A.

According to the package 1A of the second embodiment, the extension portions 21e1 to 21e3 provided behind the three sides of the lead surface S21 further enhance the anchoring effect on the lead surface S21. The lead surface S21 can be further suppressed from rising from the step portion 3 even when a compressive stress and a tensile stress are applied repeatedly between the lead frame 20 and the base 10. The same and/or similar effects are exhibited on the lead surface S22.

### (Third Embodiment)

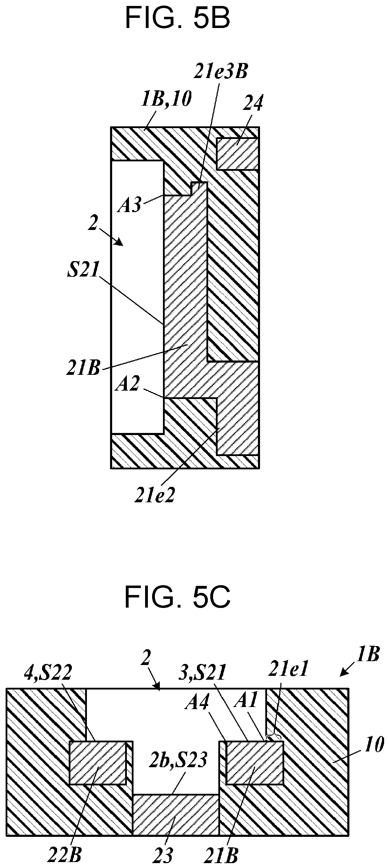

FIG. 5A is a plan view of an electronic element housing package of a third embodiment. FIG. 5B is a sectional view taken along line B-B in FIG. 5A. FIG. 5C is a sectional view taken along line C-C in FIG. 5A. A package 1B of the third embodiment is same as, and/or similar to, the package 1 of the first embodiment except a portion of the structure around each of the lead surfaces S21 and S22 of the lead frame 20.

The lead frame 20 of the third embodiment includes a first part 21B, a second part 22B, and the third to fifth parts 23 to 25. The first part 21B has the lead surface S21 exposed at the step portion 3. The second part 22B has the lead surface S22 exposed at the step portion 4.

In the same way as, and/or in a similar way to, the first embodiment, the first part 21B of the third embodiment includes the extension portions 21e1 and 21e2. The first part 21B of the third embodiment further includes an extension portion 21e3B extending outward from the lead surface S21 beyond the third side A3 and positioned inside the base 10. The third side A3 is a side extending in the lateral direction of the lead surface S21. The third side A3 and the first side A1 correspond to two sides not facing one another. The third side A3 and the second side A2 correspond to two sides facing one another. The extension portion 21e3B positioned behind the third side A3 includes a portion positioned below the third side A3 of the first part 21B and protruding in the longitudinal direction of the lead surface S21 in top view (refer to FIG. 5B). The extension portion 21e3B corresponds to an example of the third extension portion of the present disclosure.

The second part 22B has a structure same as, and/or similar to, the structure of the first part 21B.

According to the package 1B of the third embodiment, the extension portions 21e1, 21e2, and 21e3B provided behind the three sides of the lead surface S21 further enhance the anchoring effect on the lead surface S21. The lead surface S21 can be further suppressed from rising from the step portion 3 even when a compressive stress and a tensile stress are applied repeatedly between the lead frame 20 and the base 10. The same and/or similar effects are exhibited on the lead surface S22.

### (Fourth Embodiment)

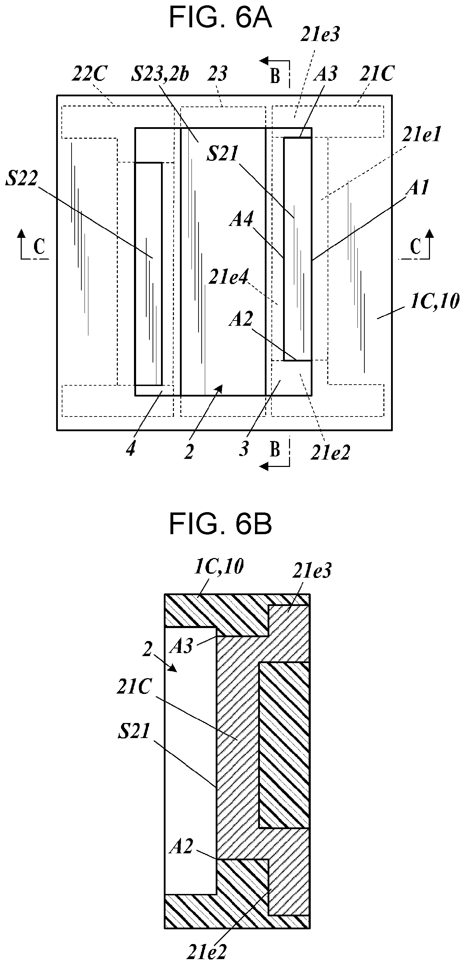

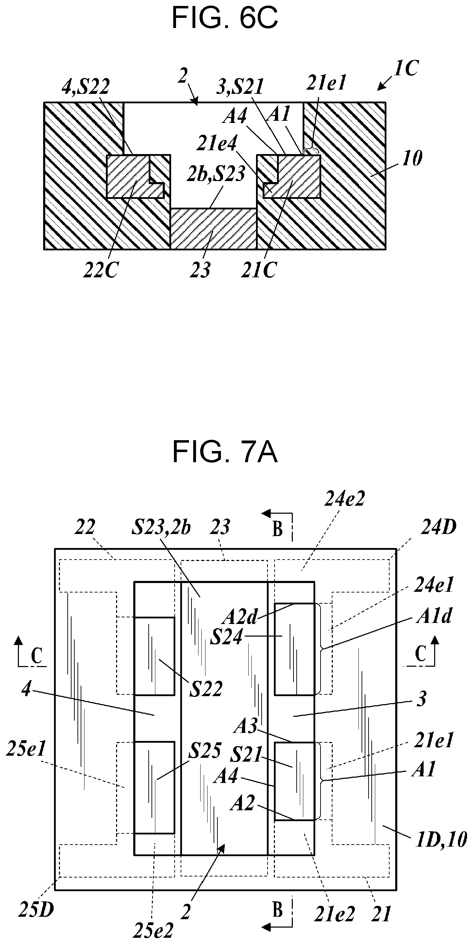

FIG. 6A is a plan view of an electronic element housing package of a fourth embodiment. FIG. 6B is a sectional view taken along line B-B in FIG. 6A. FIG. 6C is a sectional view taken along line C-C in FIG. 6A. A package 1C of the fourth embodiment is same as, and/or similar to, the package 1A of the second embodiment except a portion of the structure around each of the lead surfaces S21 and S22 of the lead frame 20.

The lead frame 20 of the fourth embodiment includes a first part 21C, a second part 22C, and the third part 23. The first part 21C has the lead surface S21. The second part 22C has the lead surface S22.

In the same way as, and/or in a similar way to, the second embodiment, the first part 21C of the fourth embodiment includes the extension portions 21e1 to 21e3. The first part 21C of the fourth embodiment further includes an extension portion 21e4 extending outward from the lead surface S21 beyond the fourth side A4 and positioned inside the base 10. The fourth side A4 is a side extending in the longitudinal direction. The fourth side A4 and the first side A1 correspond to two sides facing one another. The fourth side A4 corresponds to a side not facing the second side A2 or the third side A3. The fourth side A4 is adjacent to the second side A2 and the third side A3. The extension portion 21e4 positioned behind the fourth side A4 includes a portion positioned below the fourth side A4 of the first part 21C and protruding in the lateral direction of the lead surface S21 in top view. The extension portion 21e4 corresponds to an example of a fourth extension portion of the present disclosure.

The second part 22C has a structure same as, and/or similar to, the structure of the first part 21C.

According to the package 1C of the fourth embodiment, the extension portions 21e1 to 21e4 provided behind the entire perimeter of four sides of the lead surface S21 further enhance the anchoring effect on the lead surface S21. The lead surface S21 can be further suppressed from rising from the step portion 3 even when a compressive stress and a tensile stress are applied repeatedly between the lead frame 20 and the base 10. The same and/or similar effects are exhibited on the lead surface S22.

Note that, in the package 1C of the fourth embodiment, the extension portion 21e3B of the third embodiment may substitute for the extension portion 21e3 positioned behind the third side A3.

### (Fifth Embodiment)

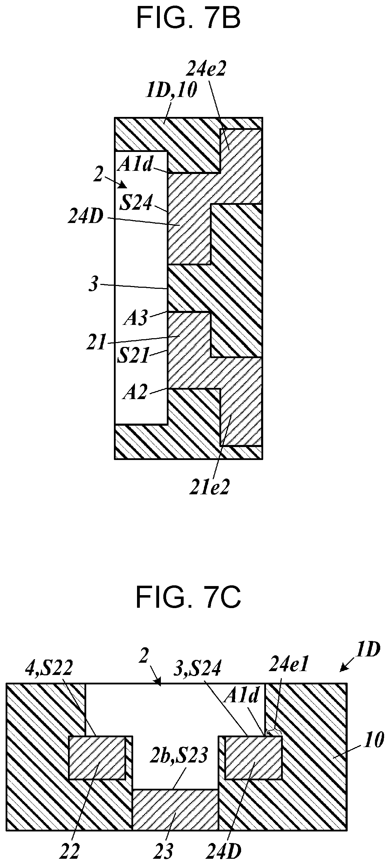

FIG. 7A is a plan view of an electronic element housing package of a fifth embodiment. FIG. 7B is a sectional view taken along line B-B in FIG. 7A. FIG. 7C is a sectional view taken along line C-C in FIG. 7A. A package 1D of the fifth embodiment is same as, and/or similar to, the package 1A of the second embodiment except the configuration of parts of the lead frame 20 and the configurations of the lead surface S21 and a lead surface S24 both exposed at the step portion 3 and the lead surface S22 and a lead surface S25 both exposed at the step portion 4.

The lead frame 20 of the fifth embodiment includes, in addition to the first to third parts 21 to 23, a fourth part 24D and a fifth part 25D. The first part 21 and the second part 22 have structures same as, and/or similar to, the first part 21 and the second part 22, respectively, of the first embodiment. However, the lead surface S21 of the first part 21 is shorten to have, for example, a length in the longitudinal direction equal to or smaller than half the length, in the longitudinal direction, of the step portion 3. The lead surface S22 of the second part 22 is also shorten to have, for example, a length in the longitudinal direction equal to or smaller than half the length, in the longitudinal direction, of the step portion 4.

The fourth part 24D has the lead surface S24 including a portion exposed at the step portion 3. The fourth part 24D further includes extension portions 24e1 and 24e2 extending outward from the lead surface S24 beyond a first side A1d and a second side A2d, respectively, not facing one another. On the step portion 3, the lead surface S24 of the fourth part 24D and the lead surface S21 of the first part 21 are arranged in the longitudinal direction.

The first side A1d behind which the extension portion 24e1 is positioned is a side extending in the longitudinal direction of the lead surface S24. The first side A1d is positioned on the boundary between the inner wall surface of the recess 2 and the upper surface of the step portion 3. The upper surface of the extension portion 24e1 is continuous with the lead surface S24.

The second side A2d behind which the extension portion 24e2 is positioned is a side extending in the lateral direction of the lead surface S24. The second side A2d is positioned on the further side from the lead surface S21 of the first part 21. The extension portion 24e2, extending from a portion thereof near the second side A2d toward an end portion thereof away from the lead surface S24, is bent downward first and is then bent in a direction parallel to the lead surface S24. A portion of the lower surface of the extension portion 24e2 is exposed at the bottom of the base 10.

The fifth part 25D has a structure same as, and/or similar to, the structure of the fourth part 24D. The fifth part 25D has the lead surface S25 including a portion exposed at the step portion 4. The fifth part 25D further includes extension portions 25e1 and 25e2 extending outward from the lead surface S25 beyond two respective sides not facing one another. On the step portion 4, the lead surface S25 of the fifth part 25D and the lead surface S22 of the second part 22 are arranged in the longitudinal direction. The extension portion 25e1 has a structure same as, and/or similar to, the structure of the extension portion 24e1 of the fourth part 24D. The extension portion 25e2 has a structure same as, and/or similar to, the structure of the extension portion 24e2 of the fourth part 24D.

As described above, according to the package 1D of the fifth embodiment, the four lead surfaces S21, S22, S24, and S25 allow a total of four electrically independent terminals to be provided on the two step portions 3 and 4. Extension portions (21e1, 21e2, 24e1, 24e2, and the like) are provided behind two sides, not facing one another, of each of the lead surfaces S21, S22, S24, and S25, and the extension portions (21e1, 21e2, 24e1, 24e2, and the like) produce an anchoring effect. Thus, the lead surfaces S21 and S24 can be suppressed from rising from the step portion 3, and the lead surfaces S22 and S25 can be suppressed from rising from the step portion 4, even when a compressive stress and a tensile stress are applied repeatedly between the lead frame 20 and the base 10.

Note that, in the first part 21 of the lead frame 20 of the fifth embodiment, the extension portion 21e3B of the third embodiment or the extension portion 21e4 of the fourth embodiment, or both the extension portions 21e3B and 21e4, may also be provided. By providing the extension portion 21e3B and/or the extension portion 21e4, an anchoring effect is produced at three sides or four sides of the lead surface S21, and the lead surface S21 can thereby be further suppressed from rising from the step portion 3. The same and/or similar effects are exhibited for the second part 22, the fourth part 24D, and the fifth part 25D.

### (Electronic Device and Electronic Module)

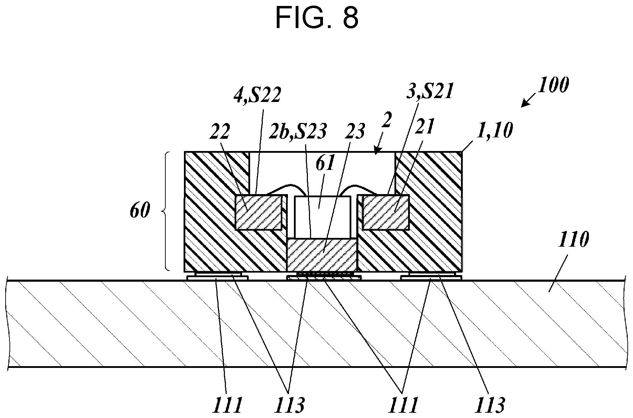

FIG. 8 is a vertical sectional view of an electronic device and an electronic module according to an embodiment of the present disclosure. In the present embodiment, an electronic device 60 includes the electronic element housing package 1 and an electronic element 61 mounted inside the recess 2 of the electronic element housing package 1. Any one of the packages 1A to 1D of the second to fifth embodiments may substitute for the package 1.

The electronic element 61 may be any element such as a surface-emitting laser chip, a semiconductor chip, an optical element, or a semiconductor element. The electronic element 61 is joined to the third part 23 of the lead frame 20, through which heat can be dissipated. The electronic element 61 is further electrically connected to the lead surfaces S21 and S22 of the step portions 3 and 4 by, for example, wire bonding. The recess 2 of the package 1 may be filled and sealed with a sealing material, or the opening of the recess 2 may be covered tightly with a lid.

In the present embodiment, an electronic module 100 includes a module substrate 110 and the electronic device 60 mounted on the module substrate 110. In addition to the electronic device 60, another electronic device(s), an electronic element(s), an electrical element(s), and/or the like may be mounted on the module substrate 110. Electrode pads 111 are provided on the module substrate 110. The electronic device 60 may be joined to the electrode pads 111 by using a joining material 113 such as solder or gold-tin.

According to the electronic device 60 and the electronic module 100 of the present embodiment, the lead surfaces S21 and S22 of the electronic device 60 can be suppressed from rising from the step portions 3 and 4, respectively, even when many reflow steps are included in a manufacturing process of the electronic device 60 or a manufacturing process of the electronic module 100. Thus, each of the electronic device 60 and the electronic module 100 can have increased reliability.

Embodiments of the present disclosure have been described above. However, the electronic element housing package, the electronic device, and the electronic module of the present disclosure are not limited to those in the above-described embodiments. For example, although the longitudinal direction of the lead surfaces is directed in the longitudinal direction of the step portions in the above-described embodiments, the configuration of the extension portions of the present disclosure may also be applied to a configuration in which the longitudinal direction of the lead surfaces is directed in the lateral direction of the step portions. By directing the lead surfaces as described above, more lead surfaces can be disposed on the step portions. In addition, the details given in the embodiments can be changed appropriately.

### INDUSTRIAL APPLICABILITY

The present disclosure is applicable to an electronic element housing package, an electronic device, and an electronic module.

### REFERENCE SIGNS

1, 1A to 1D electronic element housing package
2 recess
3, 4 step portion
10 base
20 lead frame
21, 21Ato 21C first part
21e1 extension portion (first extension portion)
21e2 extension portion (second extension portion)
21e3, 21e3B extension portion (third extension portion)
21e4 extension portion (fourth extension portion)
22, 22A to 22C second part
23 third part
24, 24D fourth part
24e1, 24e2 extension portion
25, 25D fifth part
25e1, 25e2 extension portion
S21, S22, S24, S25 lead surface
A1, A1d first side
A2, A2d second side
A3 third side
A4 fourth side
60 electronic device
100 electronic module
110 module substrate

## Claims

1. An electronic element housing package comprising:
a base made of resin; and
a lead frame including a portion positioned inside the base and another portion exposed from the base,
wherein the base includes:
a recess including a step portion,
wherein the lead frame includes:
a lead surface exposed at the step portion and having a first side and a second side;
a first extension portion extending outward from the lead surface beyond the first side, the first extension portion being positioned inside the base; and
a second extension portion extending outward from the lead surface beyond the second side, the second extension portion being positioned inside the base, and
wherein the first side and the second side are two sides not facing one another.

2. The electronic element housing package according to Claim 1,
wherein the first side is a side extending in a longitudinal direction of the lead surface, and the second side is a side extending in a lateral direction of the lead surface.

3. The electronic element housing package according to Claim 2,
wherein the longitudinal direction of the lead surface is directed in a longitudinal direction of the step portion.

4. The electronic element housing package according to any one of Claims 1 to 3,
wherein the first side is positioned on a boundary between an upper surface of the step portion and an inner wall surface of the recess.

5. The electronic element housing package according to any one of Claims 1 to 4,
wherein the second extension portion is bent and exposed on an opposite side of the base from the recess.

6. The electronic element housing package according to any one of Claims 1 to 5,
wherein the lead surface has a third side facing the second side, and
wherein the lead frame further includes a third extension portion extending outward from the lead surface beyond the third side, the third extension portion being positioned inside the base.

7. The electronic element housing package according to any one of Claims 1 to 6,
wherein the lead surface has a fourth side facing the first side, and
wherein the lead frame further includes a fourth extension portion extending outward from the lead surface beyond the fourth side, the fourth extension portion being positioned inside the base.

8. An electronic device comprising:
the electronic element housing package according to any one of Claims 1 to 7; and
an electronic element mounted inside the recess and electrically connected to the lead frame.

9. An electronic module comprising:
the electronic device according to Claim 8; and
a module substrate on which the electronic device is mounted.
